# EUROPÄISCHE PATENTSCHRIFT

(11) **EP 2 407 839 B1**
(45) Veröffentlichungstag und Bekanntmachung des Hinweises auf die Patenterteilung: **17.04.2013**
(21) Anmeldenummer: 10169526.0
(22) Anmeldetag: 14.07.2010
(51) Int. Cl.: G05B 19/042

(54) **Verfahren zum Strukturieren eines Funktionsplans in Funktionsplanbereiche**
Method for structuring a function plan into function plan areas
Procédé destiné à structurer un schéma logique dans des zones d'un schéma logique

(43) Veröffentlichungstag der Anmeldung: 18.01.2012
(73) Patentinhaber: Siemens Aktiengesellschaft, 80333 München (DE)
(72) Erfinder: Turnaus, Andre, 90562, Heroldsberg (DE)

(56) Entgegenhaltungen:
- US-A1- 2006 206 866
- US-B1- 6 931 288

## Beschreibung

Die Erfindung betrifft ein Verfahren gemäß dem Oberbegriff des Anspruchs 1.

Niederspannungsschaltgeräte (z.B. Motorstarter, Motormanagement-Systeme oder Sicherheitssysteme) zeichnen sich zunehmend durch eine Vielzahl an Geräteparametern und Gerätefunktionen aus. Komplexe Schaltgeräte sind zunehmend in der Lage, Anwendungslogik (z.B. Sicherheitsprogramme) zu verarbeiten und können damit flexibel an die Erfordernisse im Feld angepasst werden.

Die Parametrierung dieser komplexen elektronischen Schaltgeräte geschieht in der Regel auf Basis eines Engineeringsystems, welches dem Gerät sowohl die Logik als auch die Parameter zur Verfügung stellt. Ein modernes Engineeringsystem besitzt zudem eine graphische Bedienoberfläche (GUI, graphical user interface), die es dem Projekteur einfach macht, die entsprechenden Geräten zu parametrieren.

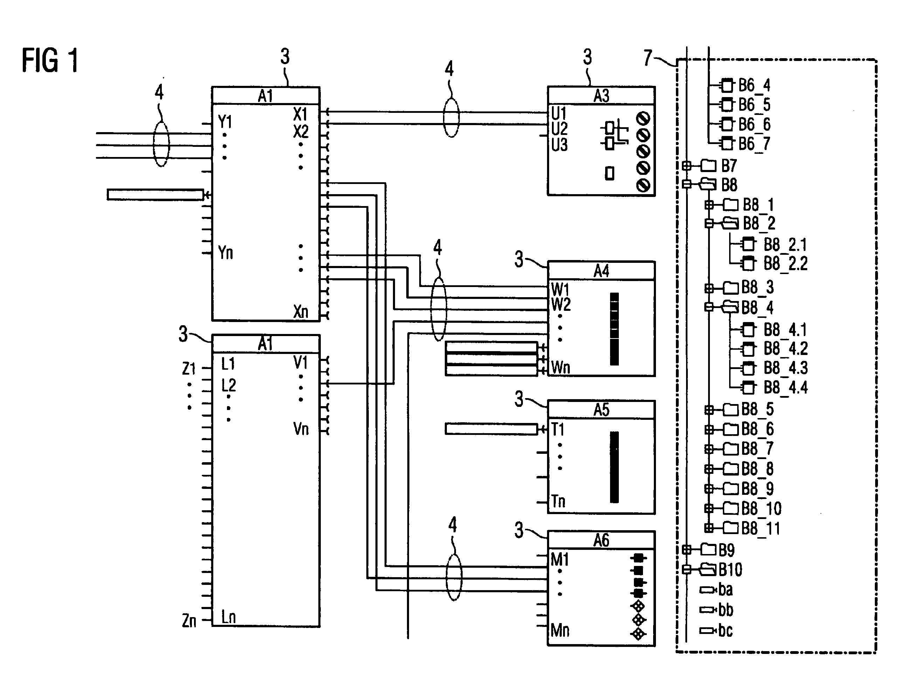

Ein Aspekt der graphischen Bedienoberfläche des Engineeringsystems ist, Funktionen, die das Gerät anbietet, dem Projekteur innerhalb eines Funktionskatalogs auswählbar und in einem Funktionsplan verschaltbar zu machen. In einem solchen Funktionsplan kann der Projekteur Funktionsbausteine miteinander verschalten und auf diese Weise eine komplette auf den spezifischen Anwendungsfall zugeschnittene Funktionslogik erstellen. Eine vereinfachte Darstellung einer graphischen Bedienoberfläche eines derartigen Engineeringsystems ist FIG 1 zu entnehmen.

Mit zunehmender Komplexität der Schaltgeräte steigt auch die Zahl der zu verschaltenden Funktionsbausteine in einem Funktionsplan. Die Pläne werden somit größer und erstrecken sich über eine Vielzahl von Seiten. Auch die Anzahl der Verbindungen (Funktionsbausteinverbindungen) zwischen den Funktionsbausteinen nimmt zu.

Eine Kernfunktionalität eines Engineeringsystems ist die Dokumentation derartiger Verschaltungspläne. Die Schwierigkeit besteht darin, komplexe und umfangreiche Verschaltungspläne (Funktionspläne) auf eine Art und Weise auszuleiten (auszudrucken), dass diese gut lesbar und interpretierbar bleiben. Nur dann dient die generierte Dokumentation nicht lediglich Archivierungszwecken sondern kann bei Optimierung der Verschaltung oder bei der Fehlersuche behilflich sein.

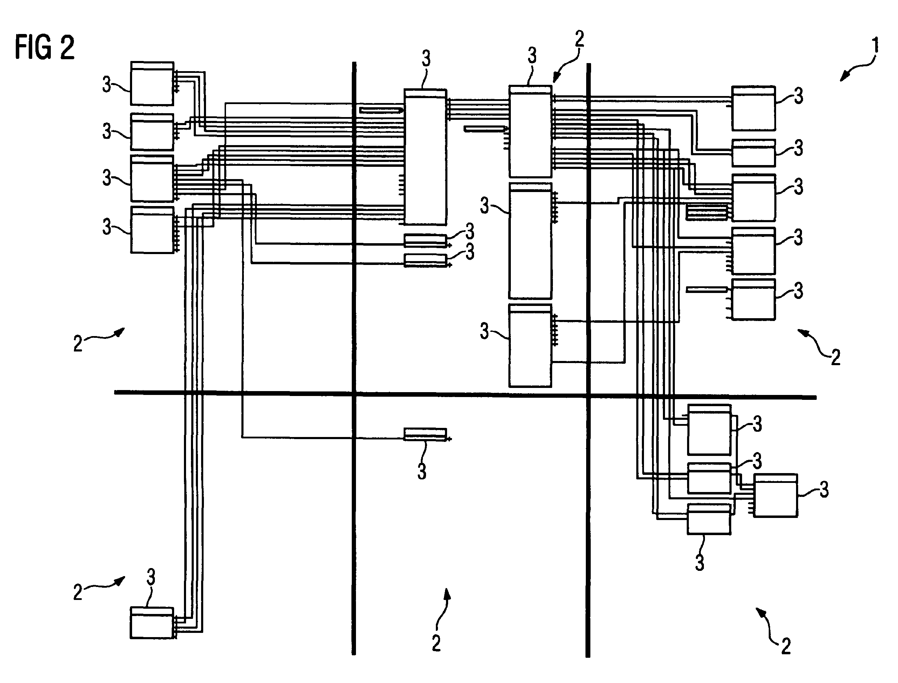

Gewöhnlich leitet die Lesbarkeit eines Funktionsplans bei der Erstellung der Dokumentation, da der Funktionsplan in n gleiche Teile aufgeteilt und jeder Teil einem Funktionsplanbereich (z.B. einer Druckseite) zugewiesen wird. Im Fall eines Ausdrucks kann beispielsweise über allgemeine Optionen die Papiergröße und das Papierformat eingestellt werden. Im Engineeringsystem wurden in der Planansicht die Seitengrenzen angezeigt, so dass der Projekteur bei der Erstellung des Plans darauf Rücksicht nehmen und die Funktionselemente entsprechend platzieren konnte. Aus FIG 2 geht beispielsweise eine Aufteilung eines Verschaltungsplans in sechs Druckseiten hervor.

Es ist daher Aufgabe der vorliegenden Erfindung, ein optimiertes Strukturieren eines Funktionsplans in Funktionsplanbereiche zu ermöglichen. Hierbei sollte vorzugsweise ein komplexer und umfangreicher Funktionsplan (Verschaltungsplan) derart in einzelne Funktionsplanbereiche strukturiert werden, dass die einzelnen Funktionsplanbereiche gut lesbar und interpretierbar bleiben.

Diese Aufgabe wird gelöst durch ein Verfahren gemäß Anspruch 1, d.h. durch ein Verfahren zum Strukturieren eines Funktionsplans in Funktionsplanbereiche, wobei der Funktionsplan Funktionsbausteine umfasst und einzelne Funktionsbausteine über mindestens eine Funktionsbausteinverbindung mit mindestens einem anderen Funktionsbaustein verbunden sind, wobei der jeweilige Funktionsplanbereich eine vordefinierte Fläche zur Abbildung mindestens eines Teils des Funktionsplans bildet, wobei die Funktionsbausteinverbindung zwischen zwei Funktionsbausteinen unterschiedlicher Funktionsbereiche des Funktionsplans eine Funktionsbausteinaußenverbindung ist, wobei wenn der Funktionsplan die vordefinierte Fläche des Funktionsplanbereichs überschreitet eine erste Ermittlung der entstehenden Funktionsbausteinaußenverbindungen bei einer Zuweisung der einzelnen Funktionsbausteine zu den einzelnen Funktionsplanbereichen je Funktionsplanvariante erfolgt und eine Zuordnung der einzelnen Funktionsbausteine zu den Funktionsplanbereichen gemäß der Funktionsplanvariante mit einer möglichst geringen Anzahl an Funktionsbausteinaußenverbindungen erfolgt, und durch ein Computerprogrammprodukt gemäß Anspruch 15 und ein Engineeringsystem gemäß Anspruch 16.

Vorteilhafte Weiterbildungen der Erfindung sind in den abhängigen Ansprüchen 2 bis 14 angegeben.

Durch das erfindungsgemäße Verfahren kann in intelligenter Weise ein Funktionsplan analysiert und letztendlich strukturiert werden. Durch eine derartige Strukturierung des Funktionsplans bzw. der Funktionsbausteine zu den entsprechenden Funktionsplanbereichen kann eine kompakte, geordnete, übersichtliche Strukturierung des Funktionsplans erfolgen.

Der Funktionsplan umfasst hierbei Funktionsbausteine. Einzelne Funktionsbausteine sind hierbei über mindestens eine Funktionsbausteinverbindung mit mindestens einem anderen Funktionsbaustein verbunden. Hierbei müssen jedoch nicht alle Funktionsbausteine untereinander verbunden sein. Ebenso ist es möglich, dass ein Funktionsbaustein mehrere Funktionsbausteinverbindungen zu einem anderen Funktionsbaustein aufweist.

Der Funktionsplanbereich weist hierbei eine vordefinierte Fläche zur Abbildung von Funktionsbausteinen sowie deren Verschaltungen auf. Ein Funktionsplanbereich kann somit mindestens einen Teil des Funktionsplans abbilden. Der Funktionsplanbereich definiert somit eine zur Verfügung stehende Fläche zur Abbildung/Strukturierung von Funktionsbausteinen sowie deren Verbindungen. Sofern ein Funktionsbaustein mit einem Funktionsbaustein eines anderen Funktionsplanbereichs verbunden ist, liegt eine Funktionsbausteinaußenverbindung vor. Zwischen den Funktionsbereichen existiert somit eine Verbindung zweier Funktionsbausteine, nämlich eine Funktionsbausteinaußenverbindung. Ist ein Funktionsbaustein mit einem Funktionsbaustein innerhalb eines Funktionsplanbereichs verbunden so liegt eine Funktionsbausteinverbindung vor.

Sofern nun der Funktionsplan die vordefinierte Fläche des Funktionsplanbereichs überschreitet, muss der Funktionsplan auf mindestens zwei Funktionsplanbereiche aufgeteilt werden. Die Anzahl bzw. der Visualisierungsbedarf der Funktionsbausteine sowie deren Verbindungen untereinander eines Fünktionsplans übersteigt somit die zur Verfügung stehende Fläche eines Funktionsplanbereichs, so dass der Funktionsplan auf mehrere Funktionsplanbereiche aufgeteilt werden muss.

Um eine möglichst übersichtliche Strukturierung des Funktionsplans über Funktionsplanbereiche zu erreichen, werden alle möglichen Szenarien der Verteilung der Funktionsbausteine auf die vorhandenen Funktionsplanbereiche betrachtet und hinsichtlich deren vorhandener Funktionsbausteinaußenverbindungen analysiert. Um eine möglichst übersichtliche Strukturierung des Funktionsplans in einzelne Funktionsplanbereiche zu ermöglichen, sollte die Anzahl der Funktionsbausteinaußenverbindungen so gering wie möglich gehalten werden. Durch eine derartige Analyse kann eine optimale Verteilung der Funktionsbausteine auf die notwendige Funktionsplanbereiche erfolgen. Bei der Analyse der einzelnen Szenarien (Funktionsplanvarianten) müssen vorzugsweise nicht alle generierbaren Varianten betrachtet werden. Über eine intelligente Filterung (z.B. Anzahl der Funktionsbausteinverbindungen zweier Funktionsbausteine untereinander) können bereits ausscheidende Varianten herausgefiltert werden.

Die letztendliche Zuordnung der einzelnen Funktionsbausteine zu den Funktionsplanbereichen erfolgt somit gemäß der Funktionsplanvariante, welche eine möglichst geringe Anzahl an Funktionsbausteinaußenverbindungen aufweist. Auf diese Weise kann eine äußerst übersichtliche und kompakte Abbildung der Verschaltungsinformationen der Funktionsbausteine untereinander erfolgen. Die aus Platzmangel herbeigeführten notwendigen Funktionsbausteinaußenverbindungen zwischen zwei Funktionsplanbereichen werden auf ein Minimum reduziert.

In einer vorteilhaften Ausführungsform der Erfindung erfolgt die Zuordnung der einzelnen Funktionsbausteine zu den Funktionsplanbereichen mit der Funktionsplanvariante mit der geringsten Anzahl an Funktionsbausteinaußenverbindungen.

Auf diese Weise kann eine Strukturierung des Funktionsplans hinsichtlich einer Reduzierung der notwendigen Funktionsbausteinaußenverbindungen auf ein Maximum reduziert werden.

In einer weiteren vorteilhaften Ausführungsform der Erfindung erfolgt eine zweite Ermittlung der Anzahl der Funktionsplanbereiche je Funktionsplanvariante und zur Zuordnung werden nur die Funktionsplanvarianten mit der geringsten Anzahl an Funktionsplanbereichen betrachtet.

Bei der Analyse der Funktionsplanvarianten wird somit vorzugsweise zunächst die Anzahl der notwendigen Funktionsplanbereiche je Funktionsplanvariante ermittelt. Daraufhin werden lediglich die Funktionsplanvarianten, welche die geringste Anzahl an Funktionsplanbereichen aufweist, dahingehend analysiert, wie groß deren jeweilige Anzahl an Funktionsbausteinaußenverbindungen ist. Die Funktionsplanvariante, mit der geringsten Anzahl an Funktionsbausteinaußenverbindungen wird letztendlich ausgewählt, so dass die Zuordnung der einzelnen Funktionsbausteine gemäß dieser Funktionsplanvariante erfolgt. Durch eine derartige Analyse kann die Anzahl der notwendigen Funktionsplanbereiche sowie der notwendigen Funktionsbausteinaußenverbindungen auf ein Minimum reduziert werden. Ein äußerst kompakte Aufteilung/Strukturierung des Funktionsplans auf die Funktionsplanbereiche kann somit erfolgen.

In einer weiteren vorteilhaften Ausführungsform der Erfindung ist eine Größe der Fläche des Funktionsplanbereichs einstellbar.

Ein Funktionsplanbereich repräsentiert eine Fläche, welche vorzugsweise zum Ausdrucken des Funktionsplans genutzt werden kann. Sofern der Funktionsplan die Größe eines Funktionsplanbereiches überschreitet muss der Funktionsplan auf mehrere Funktionsplanbereiche aufgeteilt werden, um einen Ausdruck des Funktionsplans zu ermöglichen. Hierbei ist es vorteilhaft, wenn vorzugsweise durch einen Endanwender eine Größe der zur Verfügung stehenden Fläche des Funktionsplanbereichs einstellbar ist, so dass letztendlich ein Platz definiert werden kann, welcher zur Abbildung des Funktionsplans auf einer Seite (Funktionsplanbereich) zur Verfügung steht. Die Wahl der Größe kann, sofern es sich um einen Papierausdruck handelt, beispielsweise die Wahl zwischen einem DIN A4 oder einem DIN A3 Ausdruck sein.

Vorzugsweise weist jeder Funktionsplanbereich die gleiche Größe auf. Ebenso ist es aber auch denkbar, dass die einzelnen Funktionsplanbereiche unterschiedliche Größen aufweisen, so dass beispielsweise ein Teil des Funktionsplans auf DIN A4 abgebildet wird und ein anderer Teil auf DIN A3.

Vorzugsweise wird ferner die räumliche Ausrichtung des Funktionsplanbereichs in Bezug auf den durch ihn abzubildenden Teil des Funktionsplans automatisch angepasst. Unter dem Begriff räumliche Ausrichtung ist insbesondere die Wahl zwischen Hochformat und Querformat zu verstehen. In Abhängigkeit der abzubildenden Funktionsbausteine sowie deren Verbindungen untereinander kann es beispielsweise vorteilhaft sein, einen Teil des Funktionsplans und somit einen Funktionsplanbereich als Querformt bzw. Hochformat auszurichten.

In einer weiteren vorteilhaften Ausführungsform der Erfindung weisen Funktionsbausteine unterschiedliche Typklassen auf und eine dritte Ermittlung der Funktionsbausteine gleicher Typklasse erfolgt und zur Zuordnung wird die Funktionsplanvariante, welche Funktionsbausteine der gleichen Typklasse innerhalb des jeweiligen Funktionsplanbereichs aufweist, bevorzugt betrachtet.

Ein Funktionsbaustein kann beispielsweise in folgende Typklassen unterteilt werden:
- Überwachungsbaustein,
- Steuerungsbaustein,
- Bedienungsbaustein,
- Beobachtungsbaustein,
- Bausteine zur Regelung bzw. mit verarbeitender Logik.

Zu welcher Typklasse ein Funktionsbaustein gehört, sind vorzugsweise in den Meta-Daten, d.h. im Funktionskatalog des Engineeringsystems, hinterlegt. Die Anzahl der möglichen Typklassen ist hierbei vorzugsweise nicht begrenzt. Bei der Zuordnung der Funktionsbausteine zu den Funktionsplanbereichen werden folglich die Funktionsplanvarianten bevorzugt betrachtet und letztendlich auch ausgewählt, welche innerhalb der jeweiligen Funktionsplanbereiche eine bessere Verteilung der Funktionsbausteine gleicher Typklasse aufweisen. Hierbei sollten Funktionsbausteine gleicher Typklasse möglichst gemeinsam dem gleichen Funktionsplanbereich zugewiesen werden. Auf diese Weise wird eine Strukturierung eines Funktionsplans in einzelne Funktionsplanbereiche derart verbessert, dass ein übersichtlicher und geordneter Funktionsplan entsteht.

In einer weiteren vorteilhaften Ausführungsform der Erfindung werden einem Funktionsbereich nur Funktionsbausteine gleicher Typklasse zugewiesen.

In einer weiteren vorteilhaften Ausführungsform der Erfindung können von einem Endanwender Funktionsbausteine einer vorzugsweise definierbaren Typklasse zugewiesen werden.

Auf diese Weise kann ein Endanwender beispielsweise eine Typklasse definieren und mit Hilfe dieser Typklasse eine erwünschte Strukturierung erzielen. Weist er beispielsweise mehrere Funktionsbausteine dieser Typklasse zu, so werden die Funktionsbausteine dieser Typklasse bevorzugt einem Funktionsplanbereich zugewiesen, so dass bei der Strukturierung des Funktionsplans in Funktionsplanbereiche eine erwünschte Strukturierung/Abbildung der Funktionsbausteine auf einem Funktionsplanbereich erreicht wird.

Ferner ist es denkbar, dass einzelne Typklassen untereinander zu Typklassengruppen zusammengefasst werden können. Diese Typklassengruppen sollten ebenso bevorzugt einem Funktionsplanbereich zugeordnet werden, so dass eine gezielte Strukturierung innerhalb des Funktionsplans erreicht werden kann.

In einer weiteren vorteilhaften Ausführungsform der Erfindung wird ein Funktionsplanbereich graphisch abgebildet.

Ein Funktionsplan wird letztendlich mehreren Funktionsplanbereichen zugeordnet. Ein derartiger Funktionsplanbereich weist letztendlich Funktionsbausteine sowie deren Funktionsbausteinverbindungen und Funktionsbausteinaußenverbindungen auf. Dieser Funktionsplanbereich wird nun graphisch abgebildet, so dass anhand der einzelnen Funktionsplanbereiche der Funktionsplan graphisch visualisiert wird. Ein Abbilden eines Funktionsplanbereichs kann beispielsweise über ein Druckgerät erfolgen. Hierbei entspricht ein Funktionsplanbereich einem Druckbereich einer ausgedruckten Seite. Ein Funktionsplanbereich kann somit auf das vom Druckgerät ausgegebene Papierformat visualisiert werden. Ebenso ist es denkbar, dass der Funktionsplanbereich in ein entsprechendes Dateiformat gewandelt wird (z.B. pdf-Dateiformat), so dass ein graphisches Visualisieren des Funktionsplans an einem Monitor erfolgt (eine pdf-Seite entspricht einem Funktionsplanbereich).

In einer weiteren vorteilhaften Ausführungsform der Erfindung ist über ein Eingabemittel, vorzugsweise von einem Endanwender, eine Skalierung des durch den Funktionsplanbereich abzubildenden Funktionsplans einstellbar.

Über ein Eingabemittel ist vorzugsweise von einem Endanwender eine Größe und/oder Ausrichtung des Funktionsplans innerhalb der Funktionsplanbereiche einstellbar. Wird die Skalierung des Funktionsplans beispielsweise reduziert, so kann auf einen Funktionsplanbereich eine größere Anzahl an Funktionsbausteinen abgebildet werden. Wird hingegen die Skalierung vergrößert, so werden die Funktionsbausteine größer dimensioniert und nehmen letztendlich mehr Platz auf einem Funktionsplanbereich ein. Es können folglich weniger Funktionsbausteine abgebildet werden.

In einer weiteren vorteilhaften Ausführungsform der Erfindung erfolgt eine Skalierung des durch den Funktionsplanbereich abzubildenden Funktionsplans derart, dass eine durch den Funktionsplan wiederzugebende Information (z.B. Schriftgröße) bei einer Abbildung des Funktionsplans über die einzelnen Funktionsplanbereiche eine ohne Hilfsmittel gut erkennbare Größe aufweisen.

Unter einer ohne Hilfsmittel gut erkennbaren Größe ist eine derartige Abbildungsgröße zu verstehen, welche es einem Endanwender ermöglichen einen Text bzw. eine Bezeichnung eines Geräts ohne Zuhilfenahme etwaiger Hilfsmittel (z.B. Lupe) zu lesen.

In einer weiteren vorteilhaften Ausführungsform der Erfindung ist eine Skalierung des durch den Funktionsplanbereich abzubildenden Funktionsbausteins einstellbar.

Durch eine Änderung der Skalierung des Funktionsbausteins ändert sich die Größe des Funktionsbausteins in Bezug auf einen Funktionsplanbereich. Somit ändert sich die Größe in Bezug auf die Wiedergabe/Abbildung des Funktionsbausteins, z.B. auf Papier oder auf einem Monitor.

In einer weiteren vorteilhaften Ausführungsform der Erfindung gelten für eine Skalierung der Funktionsbausteine Unter- und/oder Obergrenzen, und die Skalierung wird derart innerhalb dieses Bereichs gewählt, dass möglichst wenig Funktionsplanbereiche für den Funktionsplan erforderlich sind.

Die Unter- und/oder Obergrenzen sind vorzugsweise von einem Endanwender einstellbar. Ein Funktionsplanbereich spiegelt letztendlich bei einer Ausgabe über ein Druckgerät einen Druckbereich wieder. Für die Skalierung der Funktionsbausteine innerhalb des Druckbereichs gelten somit Unter- und/oder Obergrenzen, so dass die Verschaltungsgraphik nicht zu groß und nicht zu klein abgebildet wird. Diese Grenzwerte können systembedingt vorgegeben oder vom Anwender einstellbar sein. Durch die Unter-/Obergrenzen kann somit die Skalierung z.B. des Ausdrucks dynamisch angepasst werden, so dass ein optimales Ausnutzen des Druckbereichs bzw. der erforderlichen Funktionsplanbereiche (Seiten) erfolgen kann.

In einer weiteren vorteilhaften Ausführungsform der Erfindung wird die durch die Zuordnung bestimmte Funktionsplanvariante durch ein Ausgabesignal ausgegeben, so dass anhand dieses Ausgabesignals die durch die Zuordnung ausgewählte Funktionsplanvariante abgebildet werden kann.

Eine Verarbeitungseinheit gibt beispielsweise das Ausgabesignal aus. Ein derartiges Ausgabesignal ist beispielsweise ein Signal an ein Druckgerät, welches mittels dieses Ausgabesignals eine graphische Abbildung des Funktionsplans auf mehrere Seiten (Funktionsplanbereiche) herbeiführen kann.

In einer weiteren vorteilhaften Ausführungsform der Erfindung führt eine Verarbeitungseinheit die Ermittlung, Zuordnung und Ausgabe des Signals durch und ein Ausgabegerät bildet über das Ausgabesignal die durch die Zuordnung ausgewählte Funktionsplanvariante ab.

Im Folgenden werden die Erfindung und Ausgestaltungen der Erfindung anhand der in den Figuren dargestellten Ausführungsbeispiele näher beschrieben und erläutert. Dabei zeigen:
- FIG 1: Eine vereinfachte Darstellung einer graphischen Benutzeroberfläche eines Engineeringsystems,
- FIG 2: eine schematische Darstellung einer Aufteilung eines Funktionsplans auf sechs Funktionsplanbereiche,
- FIG 3: eine schematische Darstellung eines strukturierten Funktionsplans in Funktionsplanbereiche,
- FIG 4: eine erste Funktionsplanvarianten mit ihrer Zuordnung der Funktionsbausteine zu dem Funktionsplanbereich,
- FIG 5: eine zweite Funktionsplanvarianten mit ihrer Zuordnung der Funktionsbausteine zu dem Funktionsplanbereich und
- FIG 6: eine schematische Abbildung eines Funktionsplanbereichs, welcher Funktionsbausteine unterschiedlicher Typklassen enthält.

FIG 1 zeigt eine vereinfachte Darstellung einer graphischen Benutzeroberfläche eines Engineeringsystems. Hierbei steht einem Projekteur eine graphische Programmieroberfläche GUI zur Verfügung. Über einen Funktionskatalog 7 können Funktionsbausteine 3 ausgewählt werden. Dem Projekteur werden vorzugsweise über den Funktionskatalog 7 lediglich die Funktionen angeboten, welche das jeweilige Gerät (z.B. Schaltgerät) anbietet. Unterschiedliche Funktionsbausteine 3 können somit von dem Projekteur ausgewählt und miteinander verschaltet werden. Der Projekteur muss zur Parametrierung des Geräts lediglich die Funktionsbausteine 3 aus dem Funktionskatalog 7 auswählen und die entsprechenden Eingänge/Ausgänge der Funktionsbausteine 3 mit Funktionsbausteinverbindungen 4 verbinden. Die graphisch abgebildete Verschaltung (Funktionsbausteine 3 und deren Verbindungen 4) bildet die Logik bzw. Parametrierung eines oder mehrerer Geräte in der industriellen Umgebung ab. Eine Verdrahtung mehrerer Funktionsbausteine 3 mit Funktionsbausteinverbindungen 4 untereinander bildet letztendlich einen Funktionsplan 1. In Abhängigkeit des abzubildenden Gerätes bzw. der abzubildenden Geräte kann eine äußerst komplexe Verschaltung mehrerer Funktionsbausteine 3 untereinander erfolgen, so dass ein umfangreicher Funktionsplan 1 entsteht.

Der Funktionskatalog 7 kann beispielsweise folgende Funktionen/Funktionstypen umfassen: Melden (zyklisch, azyklisch), Standartfunktionen, Logikbausteine, Status, Störungen. Diese Funktionen sind üblicherweise über einen sortierten Strukturbaum (B1, B2, Bn) auswählbar. Hierbei sind je nach Funktionstyp Untergruppen möglich. Der Funktionstyp Logikbausteine (B8) kann beispielsweise die Untergruppen: Wahrheitstabelle 3E/1A, Wahrheitstabelle 2E/1A, Wahrheitstabelle 5E/2A, Zähler, Timer, Signalanpassung, Nullspannungssicheres Element, Blinken, Flimmern, Grenzwertmelder, Calculatoren umfassen. Hierbei kann es wiederum Untergruppen geben.

Der Funktionsbaustein 3 (A1, A2, A3, A4, A5, A6) weist hierbei Eingänge und/oder Ausgänge auf. Bei dem Funktionsbaustein 3 A6, welcher für "BB-LED" steht, werden beispielsweise über die Eingänge M1 - Mn LED's angesteuert, so dass M1 - M4 für LED Grün 1 - 4 und M5 bis M7 für LED Gelb 1 bis 3 steht. Der Funktionsbaustein 3 A1 welcher in diesem Fall für "Schützen/Steuern" steht umfasst die Eingänge Y1 - Yn (z.B.: Steuerbefehle Ein / Aus, Hilfssteuerelement RM Ein / RM Zu / RM Auf / DM Zu / DM Auf, Steuerfunktionen) sowie Ausgänge X1 - Xn (z.B.: 1QE1, 2QE2, 3QE3, 4QE4, 5QE5, QLE-Ein, QLA-Aus, QLS-Störung, Ein, Aus, Schieber Auf/Zu). Der Funktionsbaustein 3 A2 steht für "Erweitertes Schützen", wobei dessen Eingänge L1-Ln (Überlastschütz, Unsymmetrieschütz, ...) jeweiligen Schützparameterwerten Z1-Zn (z.B. Abkühlzeit, Pausenzeit, Schwelle, Verhalten, Verzögerung) zugeordnet sind. Die Ausgänge V1-Vn bilden hierbei z.B. unterschiedliche Schützzustände (Überlast, Unsymmetrie, Blockierung, usw.) ab. Der Funktionsbaustein A3 steht für "GG-Ausgänge" und weist die Eingänge U1, U2, U3 auf, A4 steht für "Zyklisch Melden 0" und weist die Eingänge W1 - Wn auf und A5 steht für "Zyklisch Melden 2/9" und weist die Eingänge T1 -Tn auf.

FIG 2 zeigt eine schematische Darstellung einer Aufteilung eines Funktionsplans 1 auf sechs Funktionsplanbereiche 2 (Druckseiten). Hierbei ist ersichtlich, dass die abgebildeten Funktionsbausteine 3 mit ihren Funktionsbausteinverbindungen je nach Anordnung im Engineeringsystem einem entsprechenden Funktionsplanbereich 2 zugewiesen sind und letztendlich auf der entsprechenden Seite ausgedruckt werden. Ein Funktionsplanbereich 2 spiegelt hierbei einen Druckbereich einer gedruckten Seite wieder. Diese Seite kann beispielsweise mit einem herkömmlichen Druckgerät beispielsweise auf eine DIN A4-Seite ausgedruckt werden. Es ist ersichtlich, dass die Funktionsbausteine 3 innerhalb unterschiedlicher Funktionsplanbereiche 2 und somit Druckseiten liegen. Bei einem Ausdrucken eines derartigen Funktionsplanes entstehen letztendlich sechs Druckseiten, auf welchen der Funktionsplan 1 abgebildet ist. Betrachtet ein Endanwender beispielsweise die unten in der Mitte abgebildete Seite, so ist lediglich ein Funktionsbaustein 3 abgebildet, dessen Funktionsbausteinverbindung aus den Funktionsplanbereich 2 ragt. Möchte der Endanwender wissen, mit welchem Funktionsbaustein 3 der auf dieser Seite abgebildete Funktionsbaustein 3 verbunden ist, so muss er die untere linke sowie die obere linke Seite heranziehen. Eine Analyse eines derart abgebildeten Funktionsplans 1 ist äußerst unübersichtlich und somit aufwändig.

Ein Nachteil einer Ausleitung eines Funktionsplans 1 mit Hilfe eines herkömmlichen Engineeringsystems besteht darin, dass bei großen Funktionsplänen 1 diese meist stark verkleinert und somit sehr schwer lesbar sind. Möchte ein Endanwender eine übersichtlichere Darstellung, so muss dieser einzelne Funktionsbaustein 3 selektieren und bei einem Ausleiten angeben, dass lediglich die ausgewählten Funktionsbausteine 3 gedruckt werden sollen. Der Nachteil einer derartigen Ausleitung besteht darin, dass kein vollständiger Funktionsplandruck vorliegt und somit keine vollständige Dokumentation eines Funktionsplans 1 erfolgt ist.

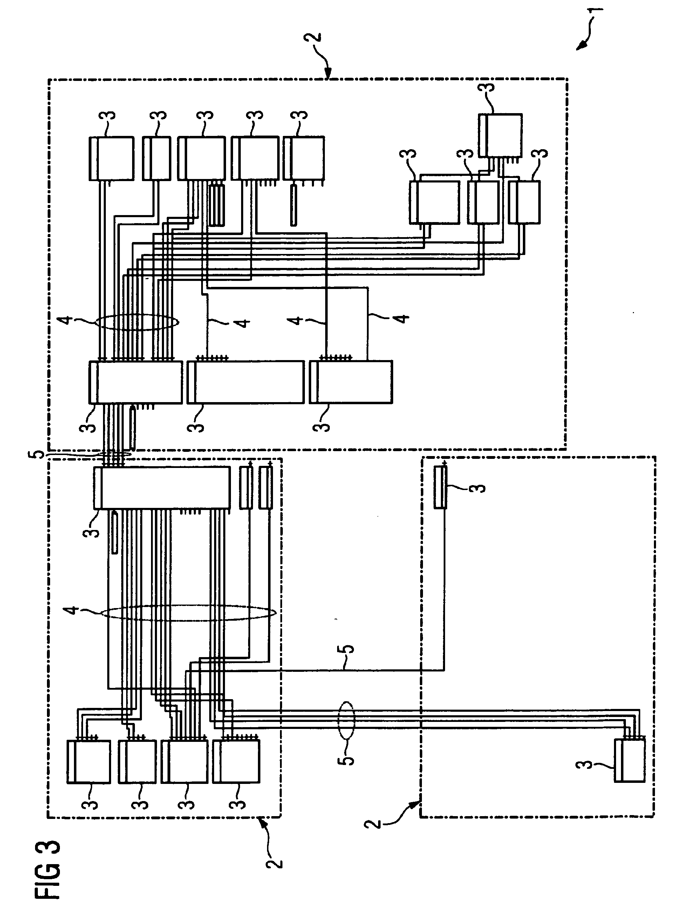

FIG 3 zeigt eine schematische Darstellung eines strukturierten Funktionsplans 1 in Funktionsplanbereiche 2. Hierbei wird der gleiche Funktionsplan 1 wiedergegeben, wie er durch FIG 2 visualisiert wurde. Dieser Funktionsplan 1 ist bezüglich seiner Funktionsplanbereiche 2 derart strukturiert, das er lediglich drei Funktionsplanbereiche 2 (Seiten) benötigt, um die einzelnen Funktionsbausteine 3 und deren Funktionsbausteinverbindungen 4,5 wiederzugeben. Die Funktionsplanbereiche 2 enthalten hierbei Funktionsbausteine 3, welche mit Funktionsbausteinverbindungen 4 untereinander verbunden sind. Sofern ein Funktionsbaustein 3 mit einem Funktionsbaustein 3 eines anderen Funktionsplanbereichs 2 verbunden ist, so spricht man von einer Funktionsbausteinaußenverbindung 5. Um eine möglichst übersichtliche Strukturierung des Funktionsplans 1 zu erreichen, wird der Funktionsplan für den Druck nicht wie bisher in gleich große Teile zugeschnitten, sondern auf intelligente Weise dynamisch (d.h. unterschiedlich große und ausgerichtete Funktionsplanbereiche) strukturiert. Der Funktionsplan 1 bzw. dessen Funktionsbausteine 3 werden derart den Funktionsplanbereichen 2 zugewiesen, dass eine möglichst geringe Anzahl an Funktionsbausteinaußenverbindungen 5 erforderlich sind.

Wie durch FIG 3 zu entnehmen ist, wurde die Anzahl der Funktionsplanbereiche 2 (Druckseiten) im Vergleich zur konventionellen Methode (Fig. 2) halbiert, ohne dass Informationen des Funktionsplans 1 verloren gingen. Der Vorteil einer derartigen Strukturierung eines Funktionsplans 1 besteht darin, dass die Festlegung der Funktionsplanbereiche 2 und somit Druckbereiche je Seite derart erfolgt, dass die gesamte Verschaltungsinformation kompakt auf möglichst wenig Seiten strukturiert wird und dennoch eine Analyse des Funktionsplans durch die einzelnen Funktionsplanbereiche 2 (Druckseiten) vereinfacht wird. Durch die Reduzierung der Funktionsbausteinaußenverbindungen 5 muss letztendlich ein Endanwender bei einem Nachverfolgen einer Funktionsbausteinverbindung 4 eines Funktionsbausteins 3 nicht ständig zwischen mehreren Funktionsplanbereichen 2 (Druckseiten) blättern. Hierdurch verbessert sich erheblich die Lesbarkeit eines Funktionsplans 1.

In FIG 3 sind ferner einzelne Funktionsbausteinverbindungen 4 hervorgehoben. Eine Funktionsbausteinverbindung ist eine Verbindung zweier Funktionsbausteine 3 miteinander.

Vorzugsweise werden bei der Strukturierung des Funktionsplans 1 in einzelne Funktionsplanbereiche 2 folgende Regeln berücksichtigt:
- Die einzelnen Funktionsplanbereiche 2 (Druckbereiche) können unterschiedlich groß sein. Jedoch haben die durch einen Funktionsplanbereich 2 (Druckbereich) abgebildeten Funktionsbausteine 3 eine gleiche Dimensionierung, so dass bei einer Ausleitung auf beispielsweise ein Papier ein Funktionsbaustein 3 auf DIN A3 dieselbe Größe aufweist, wie ein Funktionsbaustein 3 des Funktionsplans 1 auf DIN A4.
- Ein Funktionsplanbereich 2 (Druckbereich) kann entweder als Querformat oder als Hochformat ausgerichtet sein.
- Ein Funktionsplanbereich 2 (Druckbereich) wird genau einer Seite zugeordnet.
- Beim Drucken wird jeder Funktionsplanbereich 2 automatisch so skaliert, dass er papierfüllend auf einer Seite Platz findet.
- Für die Skalierung des Funktionsplans 1 innerhalb der Funktionsplanbereiche 2 gelten Unter- und Obergrenzen, so dass die Verschaltungsgraphik (die Funktionsbausteine 3 und deren Verbindungen 4,5) nicht zu groß und nicht zu klein wird. Diese Grenzwerte können systembedingt vorgegeben oder vom Anwender einstellbar sein.

Ferner ist es vorteilhaft, wenn eine Übersichtsdarstellung des Funktionsplans 1 ausgegeben werden kann, welche auf einer Seite die einzelnen Funktionsplanbereiche 2 (Druckbereiche) und deren Verbindungen untereinander (Funktionsbausteinaußenverbindungen 5) abbildet. Auf diese Weise wird es einem Anwender erleichtert, die einzelnen Druckseiten dem Funktionsplan 1 zuzuordnen.

Um eine verbesserte Strukturierung eines Funktionsplans 1 herbeizuführen, ist es wünschenswert, dass einzelne Druckbereiche (Funktionsplanbereiche 2) eine möglichst geringe Anzahl an Funktionsbausteinaußenverbindungen 5 aufweisen. Jede Funktionsbausteinaußenverbindung 5 zwischen Funktionsbausteinen 3, die über Seitengrenzen hinweg geht und folglich unterbrochen wird erschwert die Lesbarkeit eines Ausdrucks des Funktionsplans 1. Dadurch, dass bei dem erfindungsgemäßen Verfahren "Verschaltungsinseln" bzw. Teilnetzwerke gesucht werden, die möglichst nur Funktionsbausteinverbindungen 4 zwischen den einzelnen Funktionsbausteinen 3 des betroffenen Teilnetzwerks besitzen und möglichst wenig Funktionsbausteinverbindungen 4 zu anderen Teilnetzwerken aufweisen kann ein Funktionsplan 1 derart strukturiert werden, dass er mit möglichst wenigen Funktionsbausteinaußenverbindungen 5 abgebildet werden kann.

Eine Strukturierung eines Funktionsplans 1 kann beispielsweise wie folgt erfolgen. Es werden jeweils n-Funktionsbausteine 3 zu einer virtuellen Gruppe zusammengefasst, beginnend mit einem Funktionsbaustein 3. Mit jedem Schritt wird die Gruppe um einen weiteren Funktionsbaustein 3 aus der Umgebung erweitert. Nach jeder Hinzunahme eines neuen Funktionsbausteins 3 wird die temporäre Funktionsbausteingruppe in Hinblick auf die Anzahl der Funktionsbausteinaußenverbindungen 5 analysiert. Hierzu werden nicht alle Verbindungen (Funktionsbausteinverbindungen 4) des Funktionsplans 1 betrachtet und analysiert:
- Verbindungen zwischen nicht in der Gruppe befindlichen Funktionsbausteinen 3 sind nicht relevant.
- Verbindungen zwischen Funktionsbausteinen 3, die sich beide in der Gruppe befinden sind "Innenverbindungen" und werden ebenso nicht betrachtet.
- Alle anderen Verbindungen sind Funktionsbausteinaußenverbindungen 5 (Verbindungen, die das Teilnetzwerk bzw. die Gruppe verlassen). Die Anzahl dieser Funktionsbausteinaußenverbindungen 5 wird vorgemerkt.

Eine temporäre Gruppe (Funktionsbausteingruppe) wird nun gemäß oben beschriebenem Verfahren solange erweitert, bis das Teilnetzwerk so groß ist, dass es außerhalb der maximalen Skalierung eines Funktionsplanbereichs 2 bzw. des Funktionsplans 1 liegt (d.h. beim Druck unzulässig stark verkleinert werden müsste). Die Funktionsbausteingruppe mit der kleinsten Anzahl an Funktionsbausteinaußenverbindungen 5 bildet einen Funktionsplanbereich 2 (Druckbereich). Gibt es mehrere Funktionsbausteingruppen mit der gleichen Zahl an Funktionsbausteinaußenverbindungen 5, so wird diejenige Gruppe ausgewählt, die den besseren Skalierungsfaktor (z.B. Mittel aus größtem und kleinstem Skalierungsfaktor) besitzt.

Das Verfahren wird solange wiederholt, bis alle Funktionsbausteine 3 des Funktionsplans 1 erfasst sind. Bei der Zuordnung der Funktionsbausteine 3 zu den Funktionsplanbereichen 2 wird zusätzlich darauf geachtet, dass möglichst wenig Funktionsplanbereiche 2 (Druckbereiche) entstehen. Hierdurch wird eine Minimierung der Seitenzahl erzielt. D.h. beispielsweise, dass ein Druckbereich etwas vergrößert wird (und dadurch ein etwas "schlechterer" Skalierungsfaktor in Kauf genommen wird), wenn dadurch im Randbereich liegende Funktionsbausteine mit aufgenommen werden, für die sonst eigene Funktionsplanbereiche gebildet werden müssten.

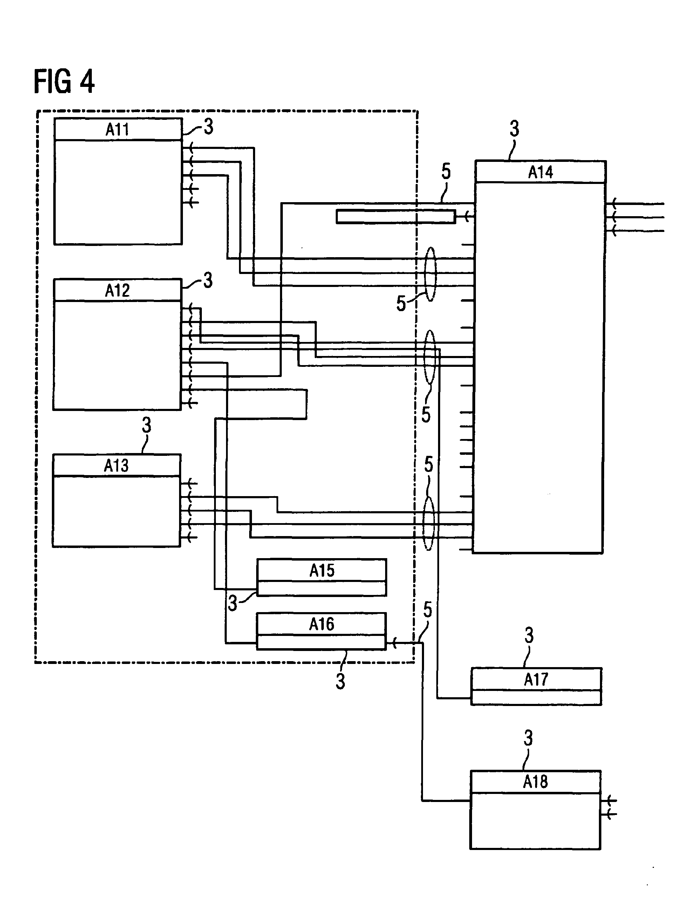

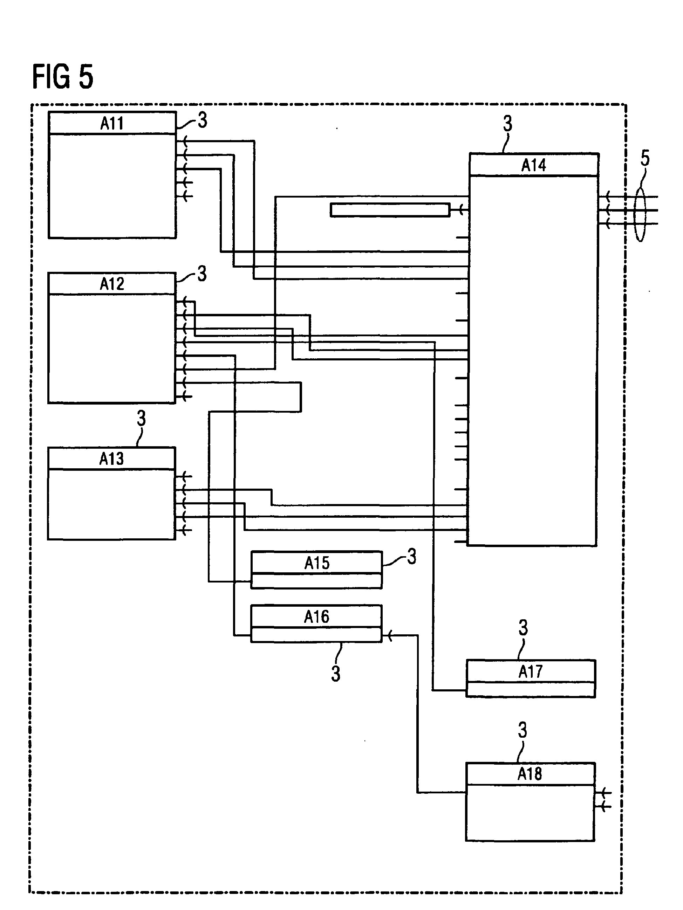

FIG 4 sowie FIG 5 zeigt zwei Funktionsplanvarianten mit ihren unterschiedlichen Zuordnung der Funktionsbausteine 3 zu dem Funktionsplanbereich 2. Hierbei ist ersichtlich, dass der Funktionsplanbereich 2 in FIG 4 mehr Funktionsbausteinaußenverbindungen 5 aufweist im Vergleich zu dem Funktionsplanbereich 2 der FIG 5. Durch die Aufnahme von drei zusätzlichen Funktionsbausteinen 3 in dem Funktionsplanbereich 2 der FIG 5 wurden die Funktionsbausteinaußenverbindungen 5 auf drei Funktionsbausteinaußenverbindungen 5 reduziert. Die Funktionsplanvariante gemäß FIG 4 weist hingegen zwölf Funktionsbausteinaußenverbindungen 5 auf. Bei dem erfindungsgemäßen Verfahren würde somit die Funktionsplanvariante gemäß FIG 5 bevorzugt werden.

Ferner können bei der Strukturierung des Funktionsplans 1 funktionelle Gesichtspunkte berücksichtigt werden. Hierbei werden alle in einem Funktionsplan 1 verschalteten Funktionsbausteine 3 zunächst analysiert und bestimmten funktionalen Typklassen zugeordnet. Beispielsweise könnten es folgenden Typklassen sein:
- Überwachungsbaustein,
- Steuerungsbaustein,
- Bedienungsbaustein,
- Beobachtungsbaustein,
- Bausteine zur Regelung bzw. mit verarbeitender Logik.

Zu welcher Typklasse ein Funktionsbaustein gehört, ist beispielsweise in den Meta-Daten, d.h. im Funktionskatalog des Engineeringsystems hinterlegt. Die Anzahl der möglichen Typklassen ist hierbei vorzugsweise nicht begrenzt.

Bei der Zuweisung der Funktionsbausteine 3 zu den einzelnen Funktionsplanbereichen 2 werden nun die Funktionsbausteine 3 der gleichen Typklasse bevorzugt zusammengefasst. Hierbei werden vorzugsweise folgende Bedingungen erfüllt:
- Funktionsbausteine 3 einer Typklasse sind nicht mehreren Funktionsplanbereichen 2 zugewiesen.
- In einem Funktionsplanbereich 2 befinden sich nur Funktionsbausteine 3 einer Typklasse.

Ebenso ist es denkbar, dass ein Endanwender eine manuelle Festlegung von Funktionsbausteinen 3 zu einer Typklasse durchführt. Auf diese Weise kann ein Endanwender Funktionsbausteine 3 derart kennzeichnen, dass sie bevorzugt auf einen Funktionsplanbereich 2 und somit einer Druckseite abgebildet werden.

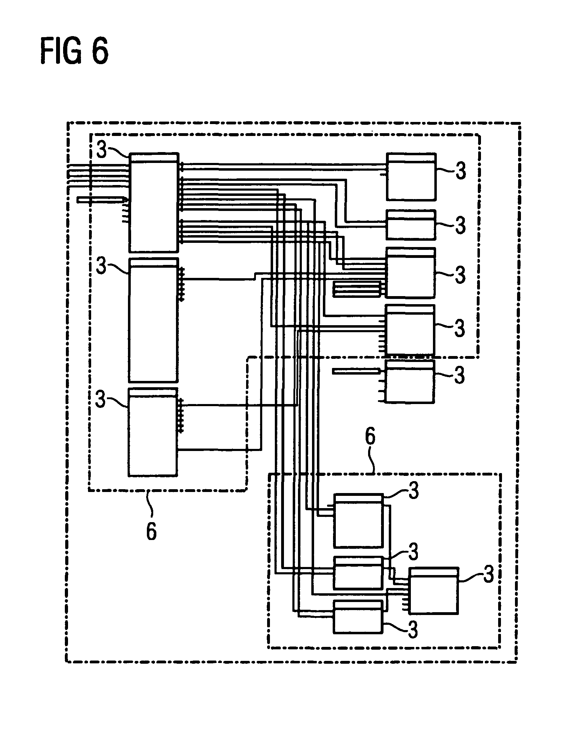

FIG 6 zeigt eine schematische Abbildung eines Funktionsplanbereichs 2, welcher Funktionsbausteine 3 unterschiedlicher Typklassen 6 enthält. Der Funktionsplanbereich 2, welcher letztendlich eine ausgedruckte Seite widerspiegelt, weist hierbei sieben Funktionsbaustein 3 einer ersten Typklasse 6, vier Funktionsbausteine 3 einer zweiten Typklasse 6 und einen Funktionsbaustein 3, welcher keiner Typklasse 6 zugeordnet ist, auf. Dadurch, dass Funktionsbausteine 3 einer gemeinsamen Typklasse 6 zugeordnet sind, werden diese bevorzugt innerhalb eines Funktionsplanbereiches 2 strukturiert.

Vorzugsweise ist es ferner möglich, dass seitens eines Endanwenders Typklassen 6 einer Typklassengruppe zugeordnet werden können, so dass deren Funktionsbausteine 3 bevorzugt innerhalb eines Funktionsplanbereichs 2 abgebildet werden.

## Patentansprüche

1. Computerimplementiertes Verfahren zum Strukturieren in Funktionsplanbereiche (2) von einem Funktionsplan (1) zur Definition der Funktionslogik in einem Engineeringsystem zur Schaltgeräteparametrierung, und zur Ausgabe des Funktionsplans an ein Ausgabegerät, so dass der Funktionsplan (1) abgebildet wird, wobei der Funktionsplan (1) Funktionsbausteine (3) umfasst und einzelne Funktionsbausteine (3) über mindestens eine Funktionsbausteinverbindung (4) mit mindestens einem anderen Funktionsbaustein (3) verbunden sind, wobei der jeweilige Funktionsplanbereich (2) eine vordefinierte Fläche zur Abbildung mindestens eines Teils des Funktionsplans (1) bildet, wobei die Funktionsbausteinverbindung (4) zwischen zwei Funktionsbausteinen (3) unterschiedlicher Funktionsplanbereiche (2) des Funktionsplans (1) eine Funktionsbausteinaußenverbindung (5) ist,
**dadurch gekennzeichnet, dass**
wenn der Funktionsplan (1) die vordefinierte Fläche des Funktionsplanbereichs (2) überschreitet eine Ermittlung möglicher runktionsplanvarianten der Verteilung der Funktionsbausteine auf die vorhandenen Funktionsplanbereiche erfolgt, eine erste Ermittlung der entstehenden Funktionsbausteinaußenverbindungen (5) bei einer Zuweisung der einzelnen Funktionsbausteine (3) zu den einzelnen Funktionsplanbereichen (2) je Funktionsplanvariante erfolgt und eine Zuordnung der einzelnen Funktionsbausteine (3) zu den Funktionsplanbereichen (2) gemäß der Funktionsplanvariante mit einer möglichst geringen Anzahl an Funktionsbausteinaußenverbindungen (5) erfolgt.

2. Verfahren nach Anspruch 1, wobei die Zuordnung der einzelnen Funktionsbausteine (3) zu den Funktionsplanbereichen (2) mit der Funktionsplanvariante mit der geringsten Anzahl an Funktionsbausteinaußenverbindungen (5) erfolgt.

3. Verfahren nach einem der vorhergehenden Ansprüche, wobei eine zweite Ermittlung der Anzahl der Funktionsplanbereiche (2) je Funktionsplanvariante erfolgt und zur Zuordnung nur die Funktionsplanvarianten mit der geringsten Anzahl an Funktionsplanbereichen (2) betrachtet werden.

4. Verfahren nach einem der vorhergehenden Ansprüche, wobei eine Größe der Fläche des Funktionsplanbereichs (2) einstellbar ist.

5. Verfahren nach einem der vorhergehenden Ansprüche, wobei Funktionsbausteine (3) unterschiedliche Typklassen (6) aufweisen und eine dritte Ermittlung der Funktionsbausteine (3) gleicher Typklasse (6) erfolgt und zur Zuordnung die Funktionsplanvariante, welche Funktionsbausteine (3) der gleichen Typklasse innerhalb des jeweiligen Funktionsplanbereichs (2) aufweist, bevorzugt betrachtet wird.

6. Verfahren nach Anspruch 5, wobei einem Funktionsplanbereich (2) nur Funktionsbausteine (3) gleicher Typklassen zugewiesen werden.

7. Verfahren nach einem der vorhergehenden Ansprüche, wobei von einem Endanwender Funktionsbausteine (3) einer vorzugsweise definierbaren Typklasse (6) zugewiesen werden können.

8. Verfahren nach einem der vorhergehenden Ansprüche, wobei ein Funktionsplanbereich (2) graphisch abgebildet wird.

9. Verfahren nach einem der vorhergehenden Ansprüche, wobei über ein Eingabemittel eine Skalierung des durch den Funktionsplanbereich (2) abzubildenden Funktionsplans (1) einstellbar ist.

10. Verfahren nach einem der vorhergehenden Ansprüche, wobei eine Skalierung des durch den Funktionsplanbereich (2) abzubildenden Funktionsplans (1) derart erfolgt, dass eine durch den Funktionsplan (1) wiederzugebenden Informationen bei einer Abbildung des Funktionsplans (1) über die einzelnen Funktionsplanbereiche (2) eine ohne Hilfsmittel gut erkennbare Größe aufweisen, wobei unter einer ohne Hilfsmittel gut erkennbaren Größe eine derartige Abbildungsgröße zu verstehen ist, welche es einem Endanwender ermöglicht einen Text bzw. eine Bezeichnung eines Geräts ohne Zuhilfenahme etwaiger Hilfsmittel zu lesen.

11. Verfahren nach einem der vorhergehenden Ansprüche, wobei eine Skalierung des durch den Funktionsplanbereich (2) abzubildenden Funktionsbausteins einstellbar ist.

12. Verfahren nach einem der vorhergehenden Ansprüche, wobei für eine Skalierung der Funktionsbausteine (3) Unter- und/oder Obergrenzen gelten, und die Skalierung derart innerhalb dieses Bereichs gewählt wird, dass möglichst wenige Funktionsplanbereiche (2) für den Funktionsplan (1) erforderlich sind.

13. Verfahren nach einem der vorhergehenden Ansprüche, wobei die durch die Zuordnung bestimmte Funktionsplanvariante durch ein Ausgabesignal ausgegeben wird, so dass anhand dieses Ausgabesignals die durch die Zuordnung ausgewählte Funktionsplanvariante abgebildet werden kann.

14. Verfahren nach Anspruch 13, wobei eine Verarbeitungseinheit die Ermittlung, Zuordnung und Ausgabe des Signals durchführt und ein Ausgabegerät über das Ausgabesignal die durch die Zuordnung ausgewählte Funktionsplanvariante abbildet.

15. Computerprogrammprodukt enthaltend Programmcodemittel zur Ausführung eines Verfahrens nach einem der Ansprüche 1 bis 14, wenn besagtes Computerprogrammprodukt auf einem Datenverarbeitungssystem ausgeführt wird.

16. Engineering System, welches dazu ausgebildet ist das Verfahren gemäß einem der Ansprüche 1 bis 14 auszuführen.

## Claims

1. Computer-implemented method for structuring a function plan (1) into function plan sections (2) for defining the function logic in an engineering system for switching device parameterization and for outputting the function plan to an output device so that the function plan (1) is represented, wherein the function plan (1) comprises function modules (3) and individual function modules (3) are connected to at least one other function module (3) via at least one function module connection (4), wherein the respective function plan section (2) forms a predefined area for representing at least one part of the function plan (1), wherein the function module connection (4) between two function modules (3) of different function sections (2) of the function plan (1) is a function module external connection (5),
**characterised in that**
if the function plan (1) exceeds the predefined area of the function plan section (2), a determination of possible function plan variants of the distribution of the function modules on the existing function plan sections occurs, a first determination of the arising function module external connections (5) in an assignment of the individual function modules (3) to the individual function plan sections (2) occurs for each function plan variant, and the individual function modules (3) are assigned to the function plan sections (2) according to the function plan variant having the smallest possible number of function module external connections (5).

2. Method according to claim 1, wherein the assignment of the individual function modules (3) to the function plan sections (2) takes place with the function plan variant having the smallest number of function module external connections (5).

3. Method according to one of the preceding claims, wherein a second determination of the number of function plan sections (2) per function plan variant occurs, and only those function plan variants having the smallest number of function plan sections (2) are examined for the purpose of assignment.

4. Method according to one of the preceding claims, wherein a size of the area of the function plan section (2) can be adjusted.

5. Method according to one of the preceding claims, wherein function modules (3) have different type classes (6) and a third determination of the function modules (3) of the same type class (6) occurs, and that function plan variant having function modules (3) of the same type class within the respective function plan section (2) is preferably examined for the purpose of assignment.

6. Method according to claim 5, wherein only function modules (3) of the same type class are assigned to a function plan section (2).

7. Method according to one of the preceding claims, wherein function modules (3) can be assigned by an end user to a type class (6) that is preferably definable.

8. Method according to one of the preceding claims, wherein a function plan section (2) is represented graphically.

9. Method according to one of the preceding claims, wherein the scale of the function plan (1) that is to be represented by the function plan section (2) can be adjusted using input means.

10. Method according to one of the preceding claims, wherein the function plan (1) that is to be represented by the function plan section (2) is scaled in such a way that any information to be rendered by the function plan (1) has a size that can be clearly recognized without means of assistance when the function plan (1) is represented by the individual function plan sections (2), wherein clearly recognized without means of assistance is understood to mean a size of representation of this type which enables an end user to read a text and/or a marking of a device without the aid of any means of assistance.

11. Method according to one of the preceding claims, wherein it is possible to adjust the scale of the function module that is to be represented by the function plan section (2).

12. Method according to one of the preceding claims, wherein lower and/or upper limits apply to any scaling of the function modules (3), and the scale is selected within this range such that the fewest possible function plan sections (2) are required for the function plan (1).

13. Method according to one of the preceding claims, wherein the function plan variant as specified by the assignment is output by means of an output signal, such that the function plan variant that has been selected by means of the assignment can be represented on the basis of this output signal.

14. Method according to claim 13, wherein a processing unit performs the determination, assignment and output of the signal, and an output device uses the output signal to represent the function plan variant that has been selected by means of the assignment.

15. Computer program product containing program code means for executing a method according to one of the claims 1 to 14 when said computer program product is executed on a data processing system.

16. Engineering system which is so designed as to execute the method according to one of the claims 1 to 14.

## Revendications

1. Procédé mis en oeuvre par ordinateur de structuration dans des zones ( 2 ) d'un schéma ( 1 ) logique pour la définition de la logique de fonction dans un système d'ingénierie pour le paramétrage d'appareils de commutation et pour l'émission du schéma logique sur un appareil d'émission, de manière à reproduire le schéma ( 1 ) logique, le schéma ( 1 ) logique comprenant des modules ( 3 ) logiques et divers modules ( 3 ) logiques étant reliés à au moins un autre module ( 3 ) logique par au moins une liaison ( 4 ) de modules logiques, la zone ( 2 ) respective de schéma logique formant une surface définie à l'avance pour la reproduction d'au moins une partie du schéma ( 1 ) logique, la liaison ( 4 ) de modules logiques entre deux modules ( 3 ) logiques de zones ( 2 ) différentes du schéma ( 1 ) logique étant une liaison ( 5 ) extérieure de modules logiques,
**caractérisé en ce que**
si le schéma ( 1 ) logique dépasse la surface définie à l'avance de la zone ( 2 ) de schéma logique, il se produit une détermination des variantes possibles de schéma logique de la répartition des modules logiques sur les zones présentes de schéma logique, une première détermination des liaisons ( 5 ) extérieures créées de modules logiques pour une affectation des divers modules ( 3 ) logiques aux diverses zones ( 2 ) de schéma logique s'effectuant pour chaque variante de schéma logique et une affectation des divers modules ( 3 ) logiques aux zones ( 2 ) du schéma logique suivant la variante de schéma logique s'effectuant avec un nombre aussi petit que possible de liaisons ( 5 ) extérieures de modules logiques.

2. Procédé suivant la revendication 1, dans lequel l'affectation des divers modules ( 3 ) logiques aux zones ( 2 ) de schéma logique s'effectue avec les variantes de schéma logique ayant le nombre le plus petit de liaisons ( 5 ) extérieures de modules logiques.

3. Procédé suivant l'une des revendications précédentes, dans lequel une deuxième détermination du nombre des zones ( 2 ) de schéma logique s'effectue par variante de schéma logique et, pour l'affectation, il n'est pris en compte que les variantes de schéma logique ayant le nombre le plus petit de zones ( 2 ) de schéma logique.

4. Procédé suivant l'une des revendications précédentes, dans lequel une grande partie de la surface de la zone ( 2 ) de schéma logique est réglable.

5. Procédé suivant l'une des revendications précédentes, dans lequel des modules ( 3 ) logiques ont des classes ( 6 ) de type différentes et une troisième détermination des modules ( 3 ) logiques de même classe ( 6 ) de type est effectuée et, pour l'affectation, on considère, de préférence, la variante de schéma logique qui a des modules ( 3 ) logiques de la même classe de type dans la zone ( 2 ) respective de schéma logique.

6. Procédé suivant la revendication 5, dans lequel seulement des modules ( 3 ) logiques de la même classe de type sont affectés à une zone ( 2 ) de schéma logique.

7. Procédé suivant l'une des revendications précédentes, dans lequel des modules ( 3 ) logiques d'une classe ( 6 ) de type pouvant être définie, de préférence, peuvent être affectés par un utilisateur final.

8. Procédé suivant l'une des revendications précédentes, dans lequel une zone ( 2 ) de schéma logique est reproduite graphiquement.

9. Procédé suivant l'une des revendications précédentes, dans lequel, par un moyen d'entrée, une mise à l'échelle du schéma ( 1 ) logique reproduisant la zone ( 2 ) de schéma logique est réglable.

10. Procédé suivant l'une des revendications précédentes, dans lequel il est effectué une mise à l'échelle du schéma logique à reproduire par la zone ( 2 ) de schéma logique, de manière à ce qu'une information à reproduire par le schéma ( 1 ) logique ait, pour une reproduction du schéma ( 1 ) logique par les diverses zones ( 2 ) de schéma logique, une grandeur bien reconnaissable sans moyen auxiliaire, en entendant par bien reconnaissable sans moyen auxiliaire une grandeur de reproduction telle qu'elle permet à un utilisateur final de lire un texte ou une caractérisation de l'appareil, sans s'aider d'un éventuel moyen auxiliaire.

11. Procédé suivant l'une des revendications précédentes, dans lequel une mise à l'échelle du module logique à reproduire par la zone ( 2 ) de schéma logique est réglable.

12. Procédé suivant l'une des revendications précédentes, dans lequel on fait valoir, pour la mise à l'échelle des modules ( 3 ) logiques, des valeurs inférieures et/ou supérieures et on choisit la mise à l'échelle dans cette plage, de manière à ce qu'aussi peu de zones ( 2 ) de schéma logique que possibles soient nécessaires pour le schéma ( 1 ) logique.

13. Procédé suivant l'une des revendications précédentes, dans lequel la variante du schéma logique déterminée par l'affectation est émise par un signal d'émission, de manière à pouvoir reproduire au moyen de ce signal d'émission la variante de schéma logique choisie par l'affectation.

14. Procédé suivant la revendication 13, dans lequel une unité de traitement effectue la détermination, l'affectation et l'émission du signal et un appareil d'émission reproduit, par le signal d'émission, la variante de schéma logique choisie par l'affectation.

15. Produit de programme informatique contenant des moyens de code de programme pour l'exécution d'un procédé suivant l'une des revendications 1 à 14, lorsque ledit produit du programme informatique est réalisé sur un système de traitement de données

16. Système d'ingénierie qui est constitué pour exécuter le procédé suivant l'une des revendications 1 à 14.
